Europäisches Patentamt

European Patent Office

Office européen des brevets

(19)

(11) Veröffentlichungsnummer: **0 047 354**
**A1**

(12) # EUROPÄISCHE PATENTANMELDUNG

(21) Anmeldenummer: **81102636.8**

(22) Anmeldetag: **08.04.81**

(51) Int. Cl.³: **H 03 H 7/40,** H 04 B 1/38,
H 04 B 1/04

(30) Priorität: **05.09.80 DE 3033407**

(43) Veröffentlichungstag der Anmeldung: **17.03.82**
**Patentblatt 82/11**

(84) Benannte Vertragsstaaten: **DE FR GB**

(71) Anmelder: **ROBERT BOSCH GMBH, Postfach 50,**
**D-7000 Stuttgart 1 (DE)**

(72) Erfinder: **Pfizenmaier, Heinz, Dipl.-Ing., Liststrasse 6,**
**D-7250 Leonberg (DE)**

(74) Vertreter: **Schmidt, Hans-Ekhardt, Robert Bosch GmbH**
**Geschäftsbereich Elektronik Patent- und**
**Lizenzabteilung Forckenbeckstrasse 9-13,**
**D-1000 Berlin 33 (DE)**

(54) **Sprechfunkgerät.**

(57) Es wird ein Sprechfunkgerät mit einem Hochfrequenzsender vorgeschlagen, dessen komplexer Ausgangswiderstand an den Fußpunktwiderstand der Sendeantenne (39)
in Abhängigkeit vom Reflexionskoeffizienten automatisch
angepaßt wird. Zur Anpassung dient ein einstellbares Anpassungsnetzwerk (19), dessen kapazitive oder induktive
Einstellelemente (35, 36) durch Regelspannungen ($U_{RB}$,
$U_{RP}$) beeinflußt werden, deren Wert von dem Phasenunterschied und von dem Betragsunterschied zwischen der
von dem Sender-Endverstärker abgegebenen Hochfrequenzleistung und der reflektierten Leistung abhängen.

40/80
EK/PLI Scht/Li
4. September 1980


ROBERT BOSCH GMBH, 7000 Stuttgart 1


Sprechfunkgerät


Stand der Technik


Die Erfindung geht aus von einem Sprechfunkgerät nach der
Gattung des Hauptanspruchs.

Bei Funksendegeräten ist es erwünscht, die in der Sender-
Endstufe erzeugte Hochfrequenzleistung möglichst verlustfrei über die Sendeantenne abzustrahlen. Dazu ist es unter
anderem erforderlich, den komplexen Ausgangswiderstand der
Sender-Endstufe an den Fußpunktwiderstand der Sendeantenne
nach Betrag und Phase anzupassen. Anderenfalls wird je
nach dem Grad der Fehlanpassung ein Teil der erzeugten
Hochfrequenzleistung an dem Fußpunkt der Sendeantenne reflektiert. Um eine möglichst genaue Anpassung zu erhalten,
kann in bekannter Weise (Diefenbach, Amateurfunk-Handbuch,
1976, Franzis-Verlag München, Seite 399) zwischen dem Ausgang der Sender-Endstufe und der Sendeantenne ein von Hand
abstimmbares Antennen-Anpassungsnetzwerk geschaltet sein.
Das Anpassungsnetzwerk ist ein Filter mit Induktivitäten
und Kondensatoren mit einstellbarem Kapazitätswert.

Bei ortsfesten Funksendegeräten, bei denen davon ausgegangen wird, daß sich der Fußpunktwiderstand der Sendeantenne
nicht verändert, braucht die Einstellung des Anpassungsnetzwerks für eine Sendefrequenz nur einmal vorgenommen zu

- 2 -

werden. Bei tragbaren Funksendegeräten, insbesondere bei
Handsprechfunkgeräten, ändert sich jedoch der Fußpunktwiderstand der Sendeantenne häufig, je nachdem, ob das
Gerät in der Hand oder am Körper getragen wird oder ob
es in einem freien Umfeld oder in der Nähe einer größeren
Metallfläche benutzt wird.

## Vorteile der Erfindung

Das erfindungsgemäße Sprechfunkgerät mit den kennzeichnenden Merkmalen des Hauptanspruchs hat den Vorteil, daß sich
der Benutzer des Gerätes um die richtige Antennenanpassung
nicht mehr zu kümmern braucht, weil die jeweils optimale
Anpassung automatisch erfolgt.

Durch die in den Unteransprüchen aufgeführten Maßnahmen
sind vorteilhafte Weiterbildungen und Verbesserungen des
im Hauptanspruch angegebenen Sprechfunkgerätes möglich.
Besonders vorteilhaft ist ein Sprechfunkgerät, bei dem an
die Stelle des Reglers ein Mikroprozessor oder Computer
tritt, der derart programmiert ist, daß er aus den Gleichspannungen Regelspannungen bildet, die eine schnelle Einstellung des Anpassungsnetzwerks bewirken. Durch die Verwendung eines Mikroprozessors bzw. eines Computers wird
erreicht, daß die Einstellung des Anpassungsnetzwerks auf
schnellstem Wege stattfindet.

## Zeichnung

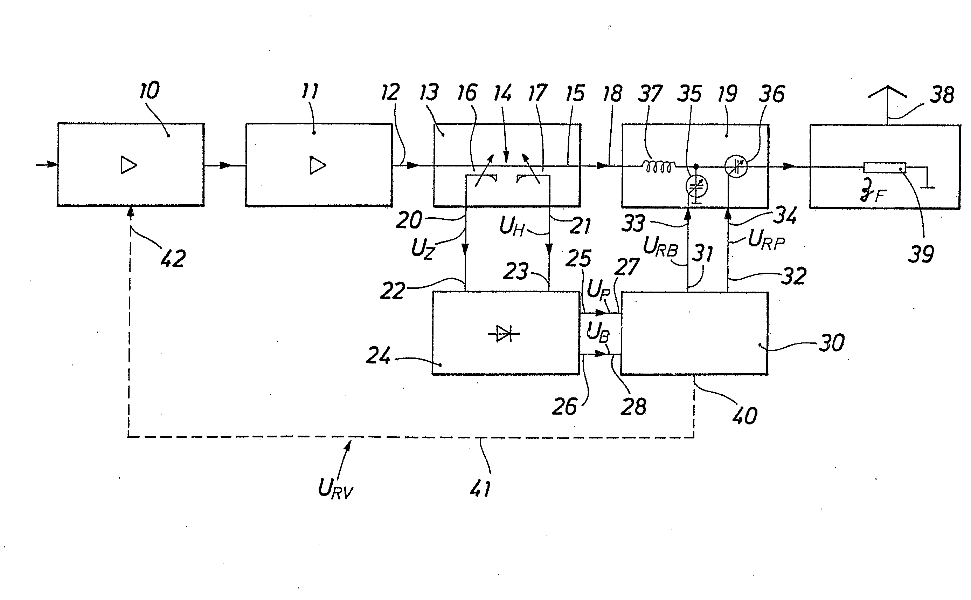

Ein Ausführungsbeispiel des erfindungsgemäßen Sprechfunkgerätes ist in der Zeichnung anhand eines stark vereinfachten Blockschaltbildes dargestellt und in der nachfolgenden
Beschreibung näher erläutert.

## Beschreibung der Erfindung

In dem Blockschaltbild eines erfindungsgemäßen Sprechfunkgerätes bezeichnet 10 eine Sender-Vorverstärkerstufe des Sprechfunkgerätes, an die sich eine Sender-Endverstärkerstufe 11 anschließt, die einen Ausgang 12 hat. Mit dem Ausgang ist eine Auskopplungsvorrichtung 13 verbunden, das ist vorzugsweise ein Leitungsrichtkoppler 14 mit einem Hauptleiter 15 und zwei Koppelleitern 16, 17. Der Hauptleiter 15 liegt zwischen dem Ausgang 12 der Sender-Endverstärkerstufe 11 und einem Eingang 18 eines einstellbaren Antennen-Anpassungsnetzwerks 19. Die Auskopplungsvorrichtung 13 hat zwei Abzweige 20 und 21, die mit den Koppelleitern 16 und 17 des Leitungsrichtkopplers 14 sowie mit je einem Eingang 22, 23 einer Detektorvorrichtung 24 verbunden sind. Die Detektorvorrichtung hat zwei Ausgänge 25 und 26, die mit je einem Eingang 27 und 28 eines Reglers 30 verbunden sind. Der Regler hat einen ersten und zweiten Ausgang 31 und 32, der über je eine Steuerleitung 33 und 34 mit je einem einstellbaren Kondensator 35 und 36 des Anpassungsnetzwerks 19 in Verbindung steht. Die Kondensatoren 35 und 36 gehören zu einem Filter, das aus einer Reihenschaltung einer Induktivität 37 und dem Kondensator 36 im Längszweig sowie dem zwischen der Induktivität 37 und dem Kondensator 36 und Masse liegenden Kondensator 35 im Querzweig besteht. Die einstellbaren Kondensatoren 35, 36 sind motorisch oder elektronisch einstellbar. Das Anpassungsnetzwerk 19 steht mit einer Sendeantenne 38 in Verbindung, deren Fußpunktwiderstand mit 39 bezeichnet ist.

Der Regler 30 hat noch einen dritten Ausgang 40, der über eine in der Zeichnung gestrichelt angedeutete Regelspannungsleitung 41 mit einem Verstärkungsregelungseingang 42 der Sender-Vorverstärkerstufe 10 verbunden ist.

Die Wirkungsweise der vorstehend beschriebenen Schaltung
ist folgende.

Eine in der Sender-Vorverstärkerstufe 10 vorverstärkte
Hochfrequenzspannung wird in der Sender-Endverstärkerstufe 11 leistungsmäßig verstärkt. Die von dem Ausgang 12
der Sender-Endverstärkerstufe abgegebene Hochfrequenzleistung gelangt über die Auskopplungsvorrichtung 13 bzw.
deren Hauptleiter 15 und über das Anpassungsnetzwerk 19
an die Sendeantenne 38. Da der komplexe Ausgangswiderstand
der Sender-Endverstärkerstufe 11 und der Fußpunktwiderstand 39 der Sendeantenne 38 nicht übereinstimmen und da
sich der Fußpunktwiderstand in Abhängigkeit von der Benutzung des Sprechfunkgerätes bzw. von der Umgebung der Sendeantenne ändern kann, das trifft insbesondere für Handsprechfunkgeräte zu, wird eine automatische Anpassung der
Widerstände vorgenommen.

Hierzu werden mittels der Auskopplungsvorrichtung 13 über
die Koppelleiter 16, 17 zwei Hochfrequenzspannungen $U_Z$ und
$U_H$ ausgekoppelt. Der Pegel der Hochfrequenzspannung $U_Z$ ist
der durch die Fehlanpassung der Sendeantenne bewirkten
reflektierten Hochfrequenzleistung und der Pegel der Hochfrequenzspannung $U_H$ der von der Sender-Endverstärkerstufe 11
abgegebenen Hochfrequenzleistung proportional. In der
Detektorvorrichtung 24 werden die beiden Hochfrequenzspannungen $U_Z$ und $U_H$ derart ausgewertet, daß an dem ersten
Ausgang 25 eine Gleichspannung $U_P$ auftritt, die der Differenz der Phasenlagen der beiden Hochfrequenzspannungen
proportional ist, und daß an dem zweiten Ausgang 26 eine
Gleichspannung $U_B$ auftritt, deren Größe dem Quotienten
zwischen der von der Sender-Endverstärkerstufe abgegebenen
und der reflektierten Hochfrequenzleistung proportional
ist.

Der Regler 30 ist nun derart beschaffen, daß er an seinem
Ausgang 31 eine Regelgleichspannung $U_{RB}$ abgibt, die über
eine Kapazitätsänderung des Kondensators 35 dafür sorgt,
daß der Realteil des komplexen Widerstandes am Ausgang 12
und der Realteil des Fußpunktwiderstandes 39 einander angepaßt werden. An dem Ausgang 32 gibt der Regler 30 eine
Regelgleichspannung $U_{RP}$ ab, die über eine Kapazitätsänderung des Kondensators 36 den bestehenden Unterschied
zwischen dem imaginären Teil des komplexen Ausgangswiderstandes am Ausgang 12 und dem imaginären Teil des komplexen Fußpunktwiderstandes auszugleichen sucht.

Ist die Anpassung annähernd optimal, dann wird keine
nennenswerte Hochfrequenzleistung reflektiert, und die
Spannung $U_Z$ wird annähernd zu Null, während die Spannung $U_H$
unverändert bleibt.

Die in dem Blockschaltbild durch eine gestrichelte Linie
angedeutete Regelspannungsleitung 41 führt eine von dem
Ausgang 40 des Reglers 30 abgegebene und dem Reflexionskoeffizienten proportionale Regelgleichspannung $U_{RV}$ an den
Steuereingang 42 der Sender-Vorverstärkerstufe 10. Dadurch
wird die Verstärkung des Vorverstärkers zunehmend herabgesetzt, wenn die reflektierte Hochfrequenzleistung bzw. der
Reflexionskoeffizient ansteigt. Dies hat zur Folge,
daß im Falle der Fehlanpassung die Sender-Endverstärkerstufe 11 durch die reflektierte Hochfrequenzleistung nicht
überlastet wird.

Die in dem Blockschaltbild angedeuteten Einzelheiten der
Auskopplungsvorrichtung 13 und des Anpassungsnetzwerks 19
sind nur als Beispiele aufzufassen. Beide Stufen 13 und 19
können auch anders aufgebaut sein. Beispielsweise kann die Auskopplungsvorrichtung 13 einen Leitungsrichtkoppler mit
einem Hauptleiter und nur einem Kopplungsleiter sein,
dessen eines Ende mit dem Abzweig 20 und dessen anderes
Ende mit dem Abzweig 21 verbunden ist. Das Anpassungsnetzwerk 19 kann gegebenenfalls ein induktiv oder induktivkapazitiv abstimmbares Filter sein.

An die Stelle des Reglers 30 kann mit Vorteil ein Mikroprozessor oder ein Computer treten, der derart programmiert
ist, daß er die zum Einstellen der abstimmbaren Elemente
des Anpassungsnetzwerkes 19 benötigten Regelspannungen in
Abhängigkeit von dem Reflexionskoeffizienten derart bemißt,
daß die optimale Widerstandsanpassung möglichst schnell
erreicht wird.

40/80
EK/PLI Scht/Li
4. September 1980

ROBERT BOSCH GMBH, 7000 Stuttgart 1

Ansprüche

1. Sprechfunkgerät mit einem Hochfrequenzsender, dessen einen komplexen Ausgangswiderstand aufweisende Endstufe mittels eines Antennen-Anpassungsnetzwerks an den Fußpunktwiderstand der Sendeantenne angepaßt ist, dadurch gekennzeichnet, daß das Antennen-Anpassungsnetzwerk (19) ein in Abhängigkeit von dem am Ausgang der Sender-Endverstärkerstufe (11) ermittelten Reflexionskoeffizienten automatisch einstellbares Anpassungsnetzwerk ist.

2. Sprechfunkgerät nach Anspruch 1, dadurch gekennzeichnet, daß an den Ausgang (12) der Sender-Endverstärkerstufe (11) eine Detektorvorrichtung (24) angekoppelt ist, die in Abhängigkeit von der Phasendifferenz und der Betragsdifferenz der von der Sender-Endverstärkerstufe abgegebenen und der reflektierten Hochfrequenzleistung je eine Gleichspannung ($U_P$, $U_B$) an einen Regler (30) abgibt, der seinerseits je eine Regelgleichspannung ($U_{RB}$, $U_{RP}$) zum Einstellen des in der Zuleitung zu der Sendeantenne (38) liegenden Anpassungsnetzwerks (19) nach Betrag und Phase abgibt.

3. Sprechfunkgerät nach Anspruch 2, dadurch gekennzeichnet, daß an die Stelle des Reglers (30) ein Mikroprozessor oder Computer tritt, der derart programmiert ist, daß er aus den Gleichspannungen ($U_P$, $U_B$) Regelspannungen ($U_{RP}$, $U_{RB}$) bildet, die eine schnelle Einstellung des Anpassungsnetzwerks (19) bewirken.

- 2 -

4. Sprechfunkgerät nach Anspruch 1, 2 oder 3, dadurch gekennzeichnet, daß die Auskopplungsvorrichtung (13) ein Richtkoppler ist.

5. Sprechfunkgerät nach Anspruch 4, dadurch gekennzeichnet, daß der Richtkoppler ein Leitungsrichtkoppler (14) ist.

6. Sprechfunkgerät nach Anspruch 5, dadurch gekennzeichnet, daß der Leitungsrichtkoppler (14) einen Hauptleiter (15) und zwei damit gekoppelte Koppelleiter (16, 17) zum Auskoppeln der von der Sender-Endverstärkerstufe (11) abgegebenen Hochfrequenzleistung und der von der Antenne reflektierten Hochfrequenzleistung aufweist.

7. Sprechfunkgerät nach Anspruch 5, dadurch gekennzeichnet, daß der Leitungsrichtkoppler (14) einen Hauptleiter (15) und nur einen damit gekoppelten Koppelleiter aufweist, dessen eines Ende mit einem Abzweig (20) und dessen anderes Ende mit dem anderen Abzweig (21) der Auskopplungsvorrichtung (13) verbunden ist.

8. Sprechfunkgerät nach einem der Ansprüche 1 bis 7, dadurch gekennzeichnet, daß das einstellbare Antennen-Anpassungsnetzwerk (19) zwei durch die Regelspannungen ($U_{RB}$, $U_{RP}$) einstellbare kapazitive oder induktive Einstellelemente (35, 36) aufweist.

9. Sprechfunkgerät nach Anspruch 2, dadurch gekennzeichnet, daß der Regler (30) eine weitere Regelspannung ($U_{RV}$) abgibt, mit der die Verstärkung der Sender-Vorverstärkerstufe (10) in Abhängigkeit von dem Reflexionskoeffizienten geregelt wird.

10

11

12  13  16  14  17  15  18  37  35  19  36

38

20  $U_H$  21

$U_Z$

42

33  34

$U_{RB}$  31  $U_{RP}$

39

$J_F$

22  23  25  27  32

24  $U_P$

$U_B$

30

26  28  40

41

$U_{RV}$

1/1

0047354

## EUROPÄISCHER RECHERCHENBERICHT

| EINSCHLÄGIGE DOKUMENTE | | | KLASSIFIKATION DER ANMELDUNG (Int. Cl.) |
|---|---|---|---|
| Kategorie | Kennzeichnung des Dokuments mit Angabe, soweit erforderlich, der maßgeblichen Teile | betrifft Anspruch | |
| X | US - A - 3 601 717 (KUECKEN)<br>* Fig. 1,5; Spalte 2, Zeile 71 - Spalte 3, Zeile 66; Spalte 4, Zeilen 26-38; Spalte 5, Zeilen 49-51 *<br>-- | 1,4 | H 03 H 7/40<br>H 04 B 1/38<br>H 04 B 1/04 |
| | US - A - 3 778 731 (ODMEN)<br>* Fig. 1,2,5; Spalte 1, Zeile 60 - Spalte 2, Zeile 54 *<br>-- | 1,2,8 | |
| | DE - A1 - 2 601 869 (THOMSON-CSF)<br>* Fig. 1-3; Seite 5, Zeile 29 - Seite 7, Zeile 1; Seite 7, Zeilen 15-24; Seite 8, Zeile 15 - Seite 9, Zeile 24 *<br>-- | 1,2,4,8 | **RECHERCHIERTE SACHGEBIETE (Int. Cl.)**<br><br>H 03 H 7/00<br>H 04 B 1/00<br>G 01 R 27/00 |
| | US - A - 4 201 960 (SKUTTA)<br>* Fig. 1; Zusammenfassung *<br>-- | 1-3 | |
| P | DD - A - 144 609 (VEB ROBOTRON-ELEKTRONIK) (22-10-1980)<br>* Fig. * <br>-- | 4-6 | |
| | HÜTTE "Des Ingenieurs Taschenbuch", 28. neubearbeitete Auflage, Hütte IVB, Elektronik Teil B, Fernmeldetechnik, 1962<br>VERLAG WILHELM ERNST & SOHN, Berlin-München<br>Seiten 198-203<br>* Bild 39 *<br>---- | 7 | **KATEGORIE DER GENANNTEN DOKUMENTE**<br><br>X: von besonderer Bedeutung<br>A: technologischer Hintergrund<br>O: nichtschriftliche Offenbarung<br>P: Zwischenliteratur<br>T: der Erfindung zugrunde liegende Theorien oder Grundsätze<br>E: kollidierende Anmeldung<br>D: in der Anmeldung angeführtes Dokument<br>L: aus andern Gründen angeführtes Dokument<br>&: Mitglied der gleichen Patentfamilie, übereinstimmendes Dokument |

| X | Der vorliegende Recherchenbericht wurde für alle Patentansprüche erstellt. | | |
|---|---|---|---|
| **Recherchenort** | **Abschlußdatum der Recherche** | **Prüfer** | |
| WIEN | 01-12-1981 | DRÖSCHER | |

EPA form 1503.1  06.78